# EUROPEAN PATENT SPECIFICATION

(11) **EP 1 841 059 B1**
(45) Date of publication and mention of the grant of the patent: **06.05.2009**
(21) Application number: 06254187.5
(22) Date of filing: 09.08.2006
(51) Int. Cl.: H03D 13/00, G01R 25/00

(54) **Phase comparator**
Phasenkomparator
Comparateur de phase

(30) Priority: 28.03.2006 JP 2006089216
(43) Date of publication of application: 03.10.2007
(73) Proprietor: Mitsubishi Electric Corporation, Chiyoda-ku Tokyo 100-8310 (JP)
(72) Inventor: Kobayashi, Tatsuya, c/o Mitsubishi Electric Corp., Tokyo 100-8310 (JP); Tagami, Hitoyuki, c/o Mitsubishi Electric Corp., Tokyo 100-8310 (JP); Shimizu, Katsuhiro, c/o Mitsubishi Electric Corp., Tokyo 100-8310 (JP); Shimomura, Kenkichi, c/o Mitsubishi Electric Corp., Tokyo 100-8310 (JP)
(74) Representative: Nicholls, Michael John

(56) References cited:
- US-A1- 2003 151 463
- US-A1- 2004 114 702
- US-B1- 6 249 188

## Description

The present invention is related to a phase comparator operable in full bit rates and also in half bit rates.

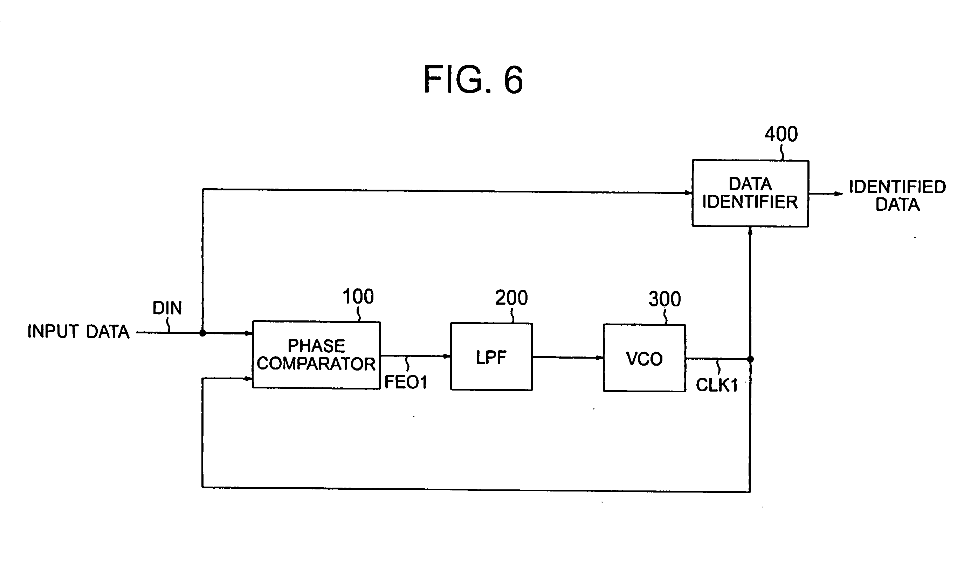

A description is made of a conventional clock data recovery circuit and a conventional phase comparator with reference to FIGS. 6 to 11 (refer to, for instance, "A Si Bipolar Phase and Frequency Detector IC for Clock Extraction up to 8 Gb/s" written byA. Pottbacker et al., IEEE Journal of Solid State Circuits, Vol. SC-27, No. 12, pp1747-1751, in 1992). FIG. 6 is a block diagram for indicating an arrangement of the conventional clock recovery circuit.

In FIG. 6, the conventional clock data recovery circuit includes a phase comparator 100, a low pass-filter (hereinafter, "LPF") 200, a voltage controled oscillator (hereinafter, "VCO") 300, and a data identifier 400.

The phase comparator 100 compares a phase of input data DIN with a phase of a clock CLK1 generated by the VCO 300, and detects a difference between the phases of the two. Then the phase comparator 100 outputs a phase difference signal FEO1 to the LPF 200. The LPF 200 smoothes the phase difference signal FEO1 by removing a higher frequency component from this signal, thereby obtaining a control signal, and outputs the control signal to the VCO 300. The VCO 300 generates the clock CLK1 by adjusting an oscillation frequency based on the control signal, and outputs the generated clock CLK1 to both the phase comparator 100 and the data identifier 400. The data identifier 400 identifies whether the input data DIN is high ("H") or low ("L") based on the clock CLK1.

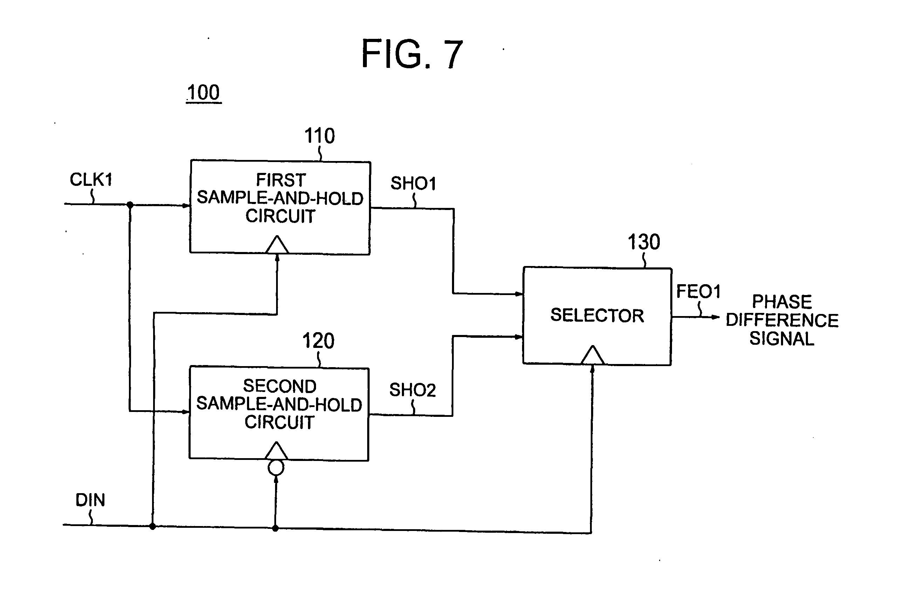

FIG. 7 is a block diagram of the phase comparator 100 shown in FIG. 6. In FIG 7, the phase comparator 100 includes a first sample-and-hold circuit 110, a second sample-and-hold circuit 120, and a selector 130.

The first sample-and-hold circuit 110 samples an amplitude value of the clock CLK1 during a period when the input data DIN is "H", and holds the amplitude value of the clock CLK1 at a fall of the input data DIN. The second sample-and-hold circuit 120 samples an amplitude value of the clock CLK1 during a period when the input data DIN is "L", and holds the amplitude value of the clock CLK1 at a rise of the input data DIN. The selector 130 selects an output SHO2 from the second sample-and-hold circuit 120 when the input data DIN is "H", and selects an output SHO1 from the first sample-and-hold circuit 110 when the input data DIN is "L". The selector 130 outputs the selected signal as the phase difference signal FEO1

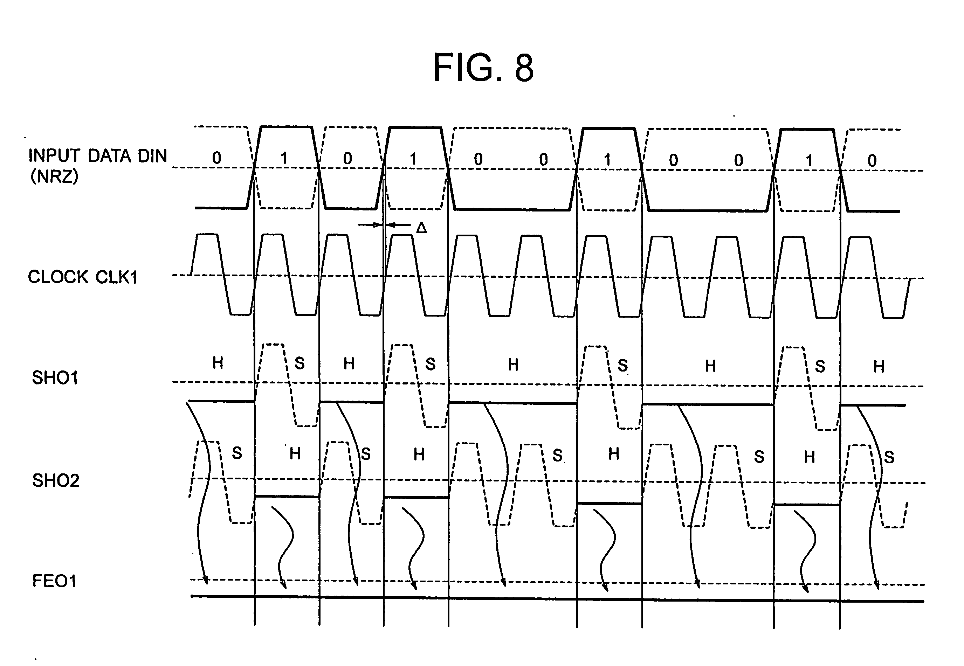

Next, operations of the phase comparator 100 will now be explained with reference to a timing chart of FIG. 8. In FIG. 8, the frequency of the clock CLK1 is equal to the bit rate of the input data DIN, and the phase comparator 100 is operated in the full bit rate. Also, the timing chart shown in FIG. 8 represents such a case that the phase of the clock CLK1 is delayed by "Δ" from the phase of the input data DIN.

The input data DIN is entered in this order of "L", "H", "L", "L" "H" "L" "L" "H" "L" "H" and "L" in a non return-to-zero (NRZ) format, namely, in the order of "0", "1", "0", "0", "1", "0", "0", "1", "0","1", and "0" (from right to left)

The first sample-and-hold circuit 110 starts a sampling operation as to the amplitude value of the clock CLK1 when the input data DIN changes from "L" to "H". The second sample-and-hold circuit 120 holds the amplitude value of the clock CLK1 at the moment when the input data DIN rises. During the period when the input data DIN is "H", the selector 130 selects the output SHO2 from the second sample-and-hold circuit 120 and outputs it as the phase difference signal FEO1.

When the input data DIN changes from "H" to "L", the first sample-and-hold circuit 110 holds the amplitude value of the clock CLK1 at the moment when the input data DIN falls. The second sample-and-hold circuit 120 starts a sampling operation as to the amplitude value of the clock CLK1. During the period when the input data DIN is "L", the selector 130 selects the output SHO1 from the first sample-and-hold circuit 110, and outputs it as the phase difference signal FEO1.

As previously explained, the phase comparator 100 detects the phase difference between the changing points (rising timing and falling timing) of the input data DIN and the rising timing of the clock CLK1 to output a constant DC (Direct Current) signals corresponding to the phase difference. It should be noted that the DC signals outputted from the phase comparator 100 have polarities while the bias level of the clock CLK1 is defined as the reference, and then, delays/leads of phases are detected based upon the polarities. The phase comparator 100 is operated in the full bit rate under normal condition in the above-described manner.

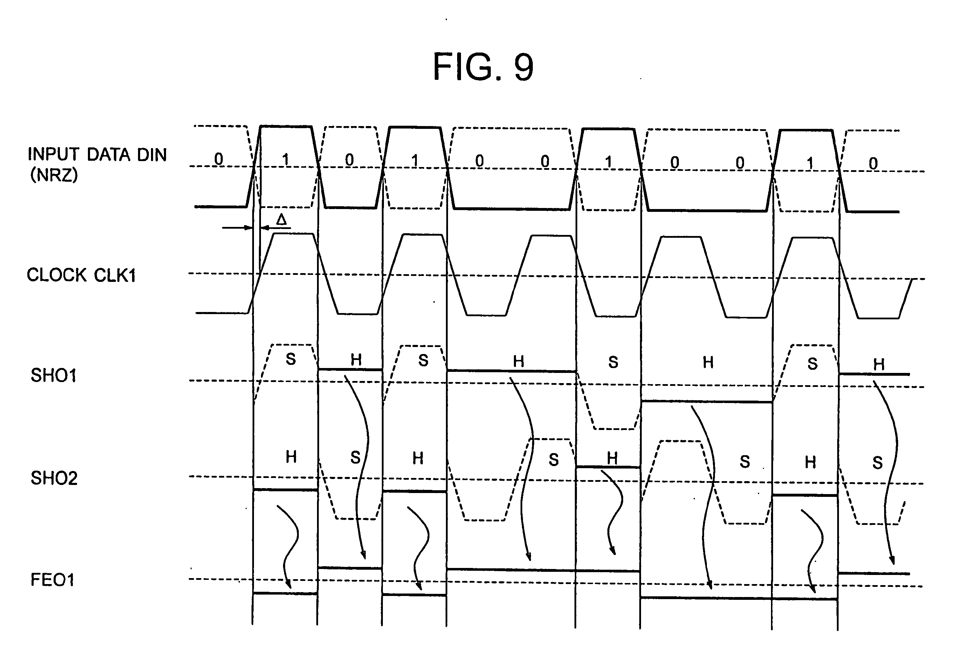

However, as indicated in a timing chart of FIG. 9, there are some possibilities that the phase comparator 100 is operated in a half bit rate in which clock CLK1 frequency is equal to a half of the bit rate of the input data DIN.

Next, operations of the phase comparator 100 will now be explained with reference to a timing chart of FIG. 9. The timing chart shown in FIG. 9 represents such a case that the phase of the clock CLK1 is delayed by "Δ" from the phase of the input data DIN.

The input data DIN is entered in this order of "L", "H", "L", "L", "H", "L", "L", "H", "L", "H" and "L" in the NRZ format, namely, in the order of "0", "1", "0", "0", "1", "0", "0", "1", "0", "1", and "0" (from right to left).

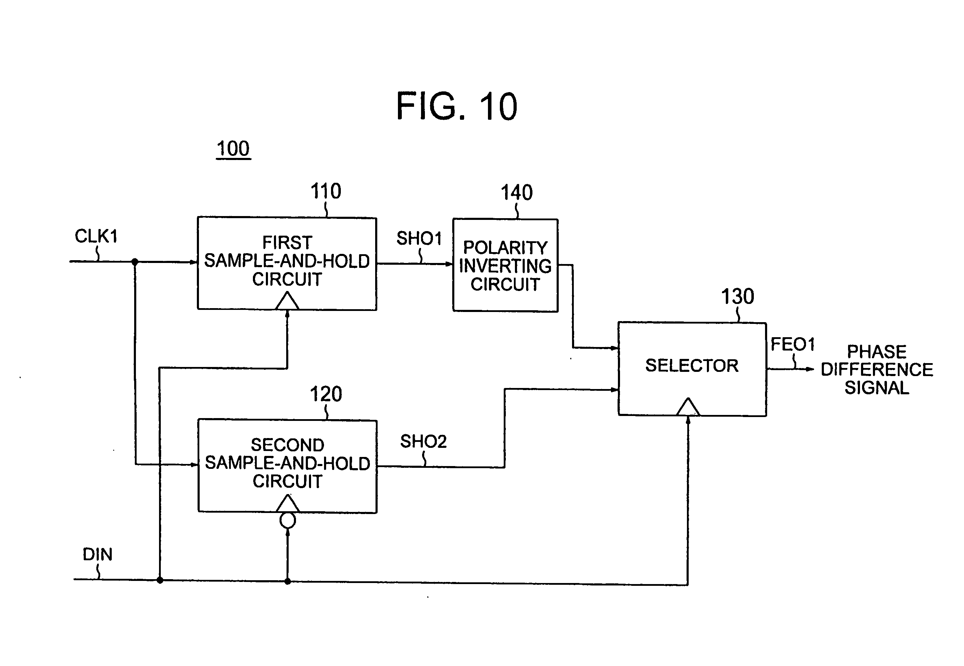

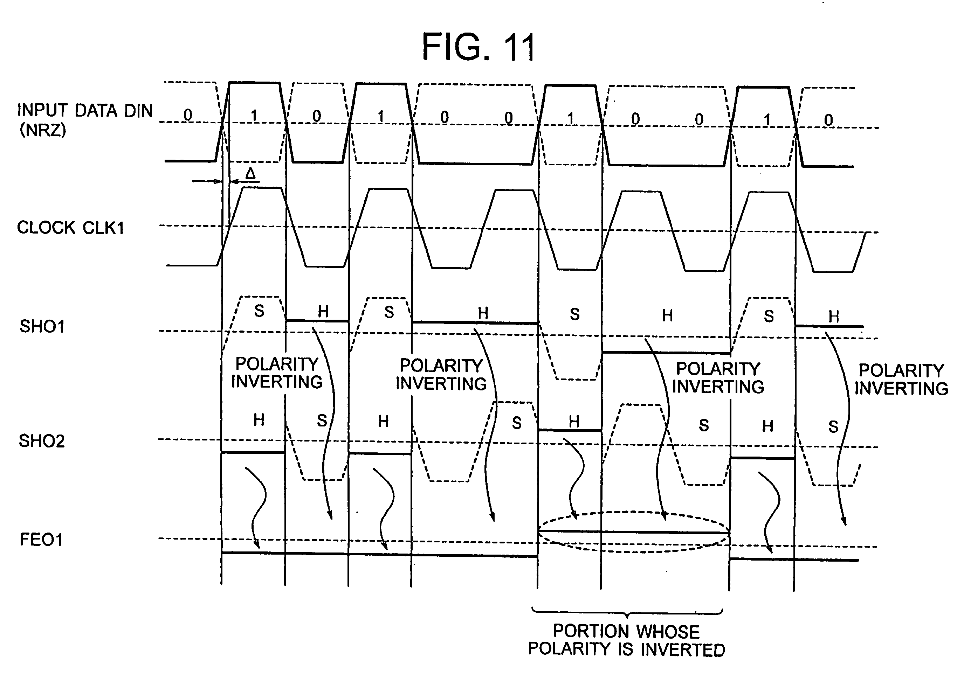

The operation of the first sample-and-hold circuit 110 and the operation of the second sample-and-hold circuit 120 are identical to those of FIG. 8. The first sample-and-hold circuit 110 holds the amplitude value under the falling state of the clock CLK1, and the second sample-and-hold circuit 120 holds the amplitude value under the rising state of the clock CLK1, so that the polarity of the output SHO1 of the first sample-and-hold circuit 110 and the polarity of the output SHO2 of the second sample-and-hold circuit 120 have an inverting relationship. In order to match the polarity of the output SHO1 of the first sample-and-hold circuit 110 coincident with the polarity of the output SHO2 of the second sample-and-hold circuit 120, for instance, as shown in FIG. 10, even if the polarity inverting circuit 140 is inserted in the output of the first sample-and-hold circuit 110, then such a signal portion surrounded by a dotted line, the polarity of which is inverted, is left in a timing chart of FIG. 11, and thus, the polarities of the output signals of the selector 130 are not matched with each other.

As previously explained, the DC signals outputted from the phase comparator 100 have the polarities. Since the delays and leads of the phases are detected based on the polarities, the polarities of the output signals of the selector 130 must be matched with each other. As previously explained, in the case that the conventional phase comparator 100 is operated in the half bit rate, the signal portions whose polarities are inverted are left in the output signals of the phase comparator 100.

The above-explained conventional sample-and-hold type phase comparator has a problem in that when the conventional sample-and-hold type phase comparator is operated in the half bit rate, the signal portions whose polarities are inverted are left in the output signals of the phase comparator.

The present invention has been made to solve the above-mentioned problem, and therefore has an object to provide a phase comparator operable in such a manner that when the phase comparator is operated not only in a full bit rate, but also in a half bit rate, a signal portion whose polarity is inverted is not left in output signals of the phase comparator, namely to provide a phase comparator operable in both the full bit rate and the half bit rate.

According to an aspect of the present invention, there is provided a phase comparator, comprising:
a first detecting means for detecting a first amplitude value of a clock signal inputted at a falling edge of an inputted data signal by starting a sampling operation for an amplitude of the clock signal at a rising edge of the inputted data signal and holding the first amplitude value of the clock signal at the falling edge of the inputted data signal;
a second detecting means for detecting an amplitude value of the clock signal at a rising edge of the inputted data signal by starting a sampling operation for the amplitude pf the clock signal at a falling edge of the inputted data signal and holding the second amplitude value of the clock signal at the rising edge of the inputted data signal;
an edge comparing means for identifying as to whether the first detecting means detects the first amplitude value during a rising state of the clock signal or the first amplitude value during a falling state of the clock signal by determining if the clock signal is in a falling state or a rising state during the falling edge of the inputted data signal to output a first identification result, and for identifying as to whether the second detecting means detects the second amplitude value during a rising state of the clock signal or the second amplitude value during a falling state of the clock signal by determining if the clock signal is in a falling state or a rising state during the rising edge of the inputted data signal to output a second identification result;
a first polarity inverting means for inverting the polarity of an output of the first detecting means in response to the first identification result derived from the edge comparing means;
a second polarity inverting means for inverting the polarity of an output of the second detecting means in response to the second identification result derived from the edge comparing means; and
a signal selecting means for selecting one of an output value of the first polarity inverting means and an output value of the second polarity inverting means in response to the polarity of the inputted data signal to output the selected output value.

The phase comparator according to the present invention has an effect that when the phase comparator is operated not only in the full bit rate, but also in the half bit rate, the signal portion whose polarity is inverted is not left in the output signals of the phase comparator, namely, such a phase comparator operable in both the full bit rate and the half bit rate can be provided.

According to a further aspect of the present invention, there is provided a phase comparator, comprising:
a ring type oscillator for producing a first clock signal and a second clock signal by delaying a phase of the first clock signal;
a first detecting means for detecting a first amplitude value of the first clock signal produced from the ring type oscillator at a falling edge of an inputted data signal by starting a sampling operation for an amplitude of the first clock signal at a rising edge of the inputted data signal and holding the first amplitude value of the first clock signal at the falling edge of the inputted data signal;
a second detecting means for detecting a second amplitude value of the first clock signal produced from the ring type oscillator at a rising edge of the inputted data signal by starting a sampling operation for the amplitude of the first clock signal at a falling edge of the inputted data signal and holding the second amplitude value of the first clock signal at the rising edge of the inputted signal;
a first identifying means for identifying a third amplitude value of the second clock signal produced from the ring type oscillator at the falling edge of the inputted data signal and holding the third amplitude value until the inputted data signal is at a subsequent falling edge to output a first identification result;
a second identifying means for identifying a fourth amplitude value of the second clock signal produced from the ring type oscillator at the rising edge of the inputted data signal and holding the fourth amplitude value until the inputted data signal is at a subsequent rising edge to output a second identification result;
a first polarity inverting means for inverting the polarity of an output of the first detecting means in response to the first identification result derived from the first identifying means;
a second polarity inverting means for inverting the polarity of an output of the second detecting means in response to the second identification result derived from the second identifying means; and
a signal selecting means for selecting one of an output value of the first polarity inverting means and an output value of the second polarity inverting means in response to the polarity of the inputted data signal to output the selected output value.

The invention will be further described by way of example with reference to the accompanying drawings, in which:-
FIG. 1 is a block diagram for representing an arrangement of a phase comparator according to a first embodiment of the present invention;
FIG. 2 is a timing chart for indicating operations of the phase comparator according to the first embodiment of the present invention;
FIG. 3 is a block diagram for representing an arrangement of a phase comparator according to a second embodiment of the present invention;
FIG. 4 is a timing chart for indicating operations of the phase comparator according to the second embodiment of the present invention;
FIG. 5 is a block diagram for representing an arrangement of a phase comparator according to a third embodiment of the present invention;
FIG. 6 is a block diagram for showing the arrangement of a conventional clock data recovery circuit;
FIG. 7 is a block diagram for indicating the arrangement of the conventional phase comparator shown in FIG. 6;
FIG. 8 is a timing chart for indicating operations (full bit rate) of the conventional phase comparator;
FIG. 9 is a timing chart for indicating operations (half bit rate) of the conventional phase comparator;
FIG. 10 is a block diagram for showing another arrangement of the conventional phase comparator; and
FIG. 11 is a timing chart for indicating operations of the conventional phase comparator shown in FIG. 10.

### First Embodiment

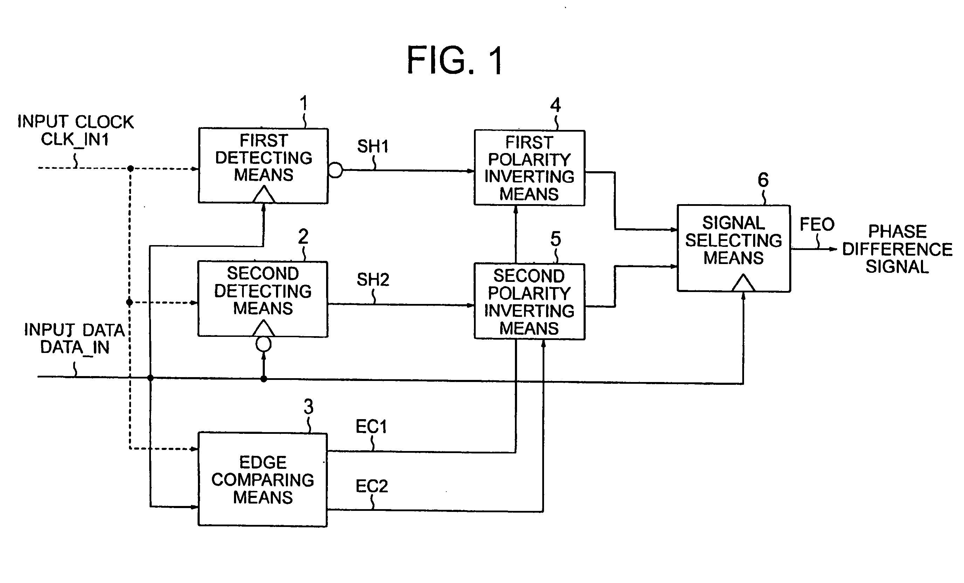

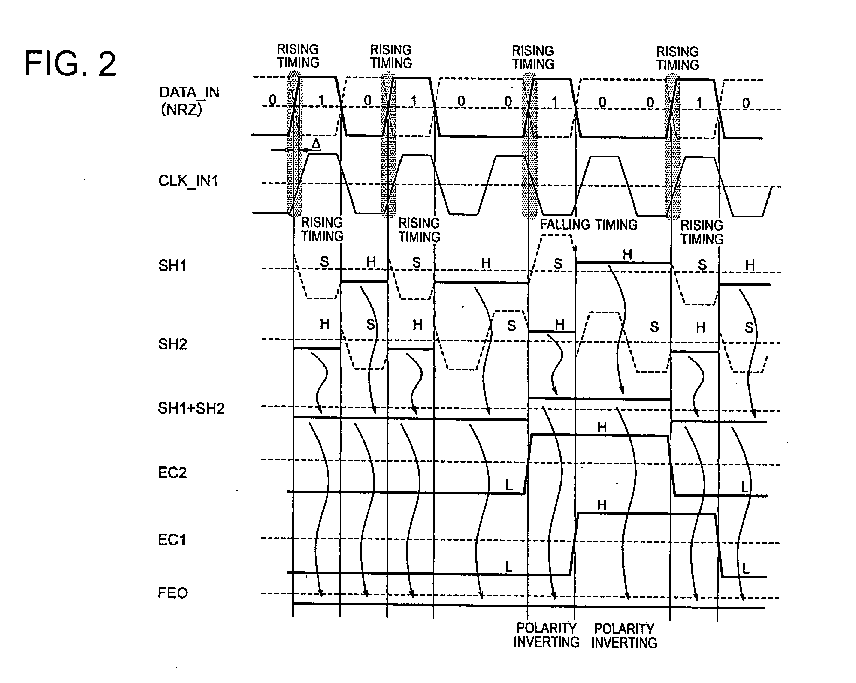

A phase comparator according to a first embodiment of the present invention will now be described with reference to FIGS. 1 and 2. FIG. 1 is a block diagram for showing an arrangement of the phase comparator according to the first embodiment of the present invention. It should be understood that the same reference numerals shown in the respective drawings indicate the same, or equivalent structural portions.

In FIG. 1, the phase comparator, according to the first embodiment, is provided with a first detecting means 1, a second detecting means 2, an edge comparing means 3, a first polarity inverting means 4, a second polarity inverting means 5, and a signal selecting means 6.

The first detecting means 1 starts a sampling operation for an amplitude of an input clock "CLK_IN1" at rising timing of input data "DATA_IN", and holds an amplitude value of the input clock "CLK_IN1" at falling timing of the input data "DATA_IN" so as to detect the input clock "CLK_IN1". Then, the first detecting means 1 outputs such a signal that a polarity of the detected value is inverted as an "SH1" to the first polarity inverting means 4.

The second detecting means 2 starts a sampling operation for the amplitude of the input clock "CLK_IN1" at falling timing of the input data "DATA_IN", and holds the amplitude value of the input clock "CLK_IN1" at rising timing of the input data "DATA_IN" so as to detect the input clock "CLK_IN1". Then, the second detecting means 2 outputs such a signal as an "SH2" to the second polarity inverting means 5.

Similarly the first detecting means 1 and the second detecting means 2, the edge comparing means 3 employs both the input data DATA_IN and the input clock CLK_IN1. This edge comparing means 3 identifies as to whether the first detecting means 1 detects an amplitude value under a rising state of the input clock CLK_IN1, or an amplitude value under a falling state thereof, and then, outputs an "EC1" corresponding to an identification result to the first polarity inverting means 4. Also, the edge comparing means 3 identifies as to whether the second detecting means 2 detects an amplitude value under a rising state of the input clock CLK_IN1, or an amplitude value under a falling state thereof, and then, outputs an "EC2" corresponding to an identification result to the second polarity inverting means 5.

The signal selecting means 6 selects either an output value of the first polarity inverting means 4 or an output value of the second polarity inverting means 5 in response to a polarity (either "H" or "L") of the input data DATA_IN to output the selected output value.

Referring subsequently to drawings, a description is made of operations of the phase comparator according to the first embodiment. FIG. 2 is a timing chart for indicating the operations of the phase comparator according to the first embodiment of the present invention. The timing chart shown in FIG. 2 shows such a case that a phase of the input clock CLK_IN is delayed by "Δ", as compared with a phase of the input data DATA_IN.

The input data DATA_IN is entered in this order of "L", "H", "L", "L", "H", "L", "L", "H", "L", "H" and "L" in the NRZ format, namely, in the order of "0", "1", "0", "0", "1", "0", "0", "1", "0","1", and "0" (from right to left).

When the input data DATA_IN is changed from "L" to "H", the first detecting means 1 starts a sampling operation as to an amplitude value of the input clock CLK_IN1. Also, the second detecting means 2 holds an amplitude value of the input clock CKL_IN1 at rising timing of the input data DATA_IN.

When the input data DATA_IN is changed from "H" to "L", the first detecting means 1 holds an amplitude value of the input clock CLK_IN1 at falling timing of the input clock CLK_IN1. Also, the second detecting means 2 starts a sampling operation as to the amplitude value of the input clock CLK_IN1.

If a changingpoint of the input clock CLK_IN1 is under a falling state when the input data DATA_IN is changed from "H" to "L" in the first detecting means 1, then the edge comparing means 3 outputs "L" as the EC1, whereas if a changing point of the input clock CLK_IN1 is under a rising state when the input data DATA_IN is changed from "H" to "L" in the first detecting means 1, then the edge comparing means 3 outputs "H" as the EC1. Then, the edge comparing means 3 holds this output until the input data DATA_IN is subsequently changed from "H" to "L".

If a changing point of the input clock CLK_IN1 is under a rising state when the input data DATA_IN is changed from "L" to "H" in the second detecting means 2, then the edge comparing means 3 outputs "L" as the EC2, whereas if a changing point of the input clock CLK_IN1 is under a falling state when the input data DATA_IN is changed from "L" to "H" in the second detectingmeans 2, then the edge comparing means 3 outputs "H" as the EC2. Then, the edge comparing means 3 holds this output until the input data DATA_IN is subsequently changed from "L" to "H".

If the EC1 is "L", then the first polarity inverting means 4 does not invert the polarity, whereas if the EC1 is "H", then the first polarity inverting means 4 inverts the polarity. If the EC2 is "L", then the second polarity inverting means 5 does not invert the polarity, whereas if the EC2 is "H", then the second polarity inverting means 5 inverts the polarity. Then, in a time period during which the input data DATA_IN is "H", the signal selecting means 6 selects an output of the second polarity inverting means 5 to output the selected signal as a phase difference signal "FEO". Also, in a time period during which the input data DATA_IN is "L", the signal selecting means 6 selects an output of the first polarity inverting means 4 to output the selected signal as a phase difference signal "FEO".

As previously explained, in the first embodiment, the edge comparing means 3 identifies as to whether both the first detecting means 1 and the second detecting means 2 detect the amplitude values of the input clocks CLK_IN1 under the rising states, or detect the amplitude values thereof under the falling sates. Then, the edge comparing means 3 determines to invert/non-invert the polarities of the output of the first polarity inverting means 4 and the output of the secondpolarity invertingmeans 5 based upon the identification results, so that the polarities of the phase difference signals FEOs can be made matched with each other. Also, by invalidating the operations of the first polarity inverting means 4 and the second polarity inverting means 5, the phase comparator can also be operated in the full bit rate.

### Second Embodiment

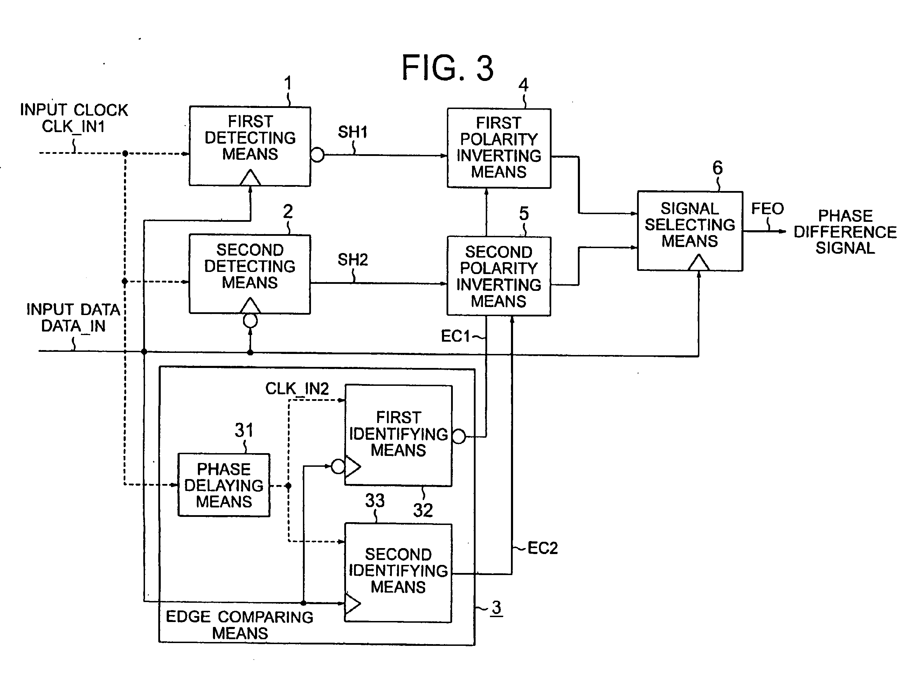

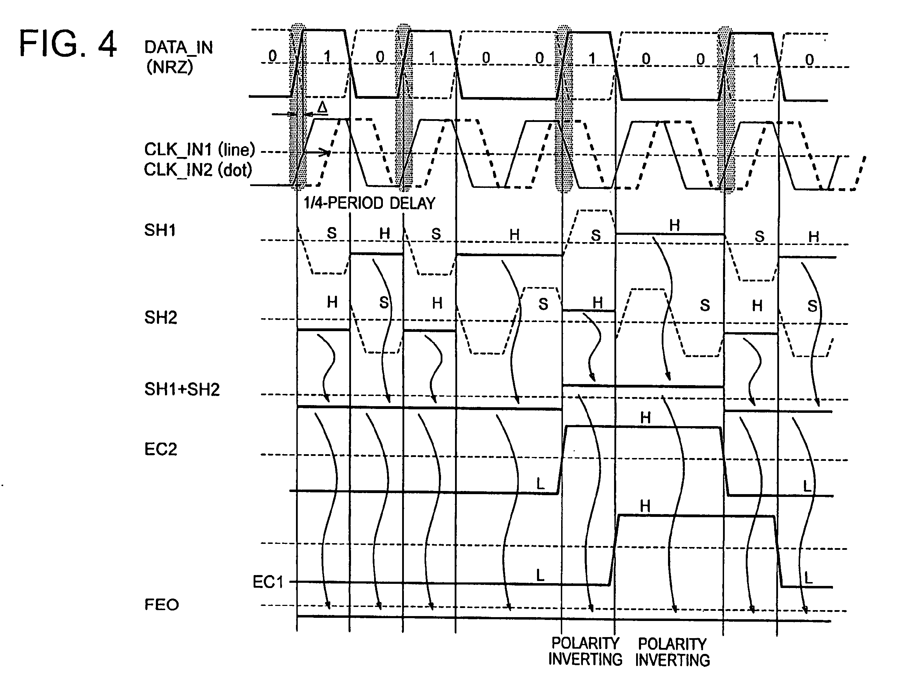

A phase comparator according to a second embodiment of the present invention will now be described with reference to FIGS. 3 and 4. FIG. 3 is a block diagram for showing an arrangement of the phase comparator according to the second embodiment of the present invention.

In FIG. 3, the phase comparator, according to the second embodiment, is provided with the first detecting means 1, the second detecting means 2, the edge comparing means 3, the first polarity inverting means 4, the second polarity inverting means 5, and the signal selecting means 6.

Also, the edge comparing means 3 is constituted by a phase delaying means 31, a first identifying means 32, and a second identifying means 33.

The first detecting means 1 starts a sampling operation for the amplitude of the input clock "CLK_IN1" at rising timing of the input data "DATA_IN", and holds the amplitude value of the input clock "CLK_IN1" at falling timing of the input data "DATA_IN" so as to detect the input clock "CLK_IN1" . Then, the first detecting means 1 outputs such a signal that a polarity of the detected value is inverted as an "SH1" to the first polarity inverting means 4.

The second detecting means 2 starts a sampling operation for the amplitude of the input clock "CLK_IN1" at falling timing of the input data "DATA_IN", and holds the amplitude value of the input clock "CLK_IN1" at rising timing of the input data "DATA_IN" so as to detect the input clock "CLK_IN1" . Then, the second detecting means 2 outputs such a signal as an "SH2" to the second polarity inverting means 5.

The phase delaying means 31 delays the phase of the input clock CLK_IN1 by, for example, a 1/4 time period, and then, outputs the delayed clock CLK_IN2 to the first identifying means 32 and the second identifying means 33. The first identifying means 32 identifies the delayed clock CLK_IN2 at falling timing of the input data DATA_IN, and then, outputs an inverted signal of this identification result as an "EC1" to the first polarity inverting means 4. The second identifying means 33 identifies the delayed clock CLK_IN2 at rising timing of the input data DATA_IN, and then, outputs this identification result as an "EC2" to the second polarity inverting means 5.

The signal selecting means 6 selects either an output value of the first polarity inverting means 4 or an output value of the second polarity inverting means 5 in response to a polarity (either "H" or "L") of the input data DATA_IN to output the selected output value.

Referring subsequently to drawings, a description is made of operations of the phase comparator according to the second embodiment. FIG. 4 is a timing chart for indicating the operations of the phase comparator according to the second embodiment of the present invention. The timing chart shown in FIG. 4 shows such a case that a phase of the input clock CLK_IN is delayed by "Δ", as compared with a phase of the input data DATA_IN.

The input data DATA_IN is entered in this order of "L", "H", "L", "L", "H", "L", "L", "H", "L", "H" and "L" in the NRZ format, namely, in the order of "0", "1", "0", "0", "1", "0", "0", "1", "0","1", and "0" (from right to left).

When the input data DATA_IN is changed from "L" to "H", the first detecting means 1 starts a sampling operation as to an amplitude value of the input clock CLK_IN1. Also, the second detecting means 2 holds an amplitude value of the input clock CKL_IN1 at rising timing of the input data DATA_IN.

When the input data DATA_IN is changed from "H" to "L", the first detecting means 1 holds an amplitude value of the input clock CLK_IN1 at falling timing of the input clock CLK_IN1. Also, the second detecting means 2 starts a sampling operation as to the amplitude value of the input clock CLK_IN1.

Since the first identifying means 32 which constitutes the edge comparing means 3 identifies the delayed clock CLK_IN2 at the falling timing of the input data DATA_IN and then inverts the identification, the output of the first identifying means 32 becomes "EC1" indicated in FIG. 4. Since a portion of an SH1 whose polarity is wanted to be inverted enters an "H" section of the EC1, the polarities of the SH1 can be matched with each other by inverting the polarities of the SH1 by the first polarity inverting means 4 only in the case that the EC1 is "H".

Also, since the second identifying means 33 which constitutes the edge comparing means 3 identifies the delayed clock CLK_IN2 at the rising timing of the input data DATA_IN, the output of the second identifying means 33 becomes "EC2" indicated in FIG. 4. Since a portion of an SH2 whose polarity is wanted to be inverted enters an "H" section of the EC2, the polarities of the SH2 can be matched with each other by inverting the polarities of the SH2 by the second polarity inverting means 5 only in the case that the EC2 is "H".

Then, in a time period during which the input data DATA_IN is "H", the signal selecting means 6 selects an output signal of the second polarity inverting means 5 to output the selected output signal as a phase difference signal FEO. Also, in a time period during which the input data DATA_IN is "L", the signal selecting means 6 selects an output signal of the first polarity inverting means 4 to output the selected output signal as the phase difference signal FEO.

As previously explained, in the second embodiment, the edge comparing means 3 produces the delayed clock CLK_IN2 by delaying the input clock CLK_IN1, and identifies this delayed clock CLK_IN2 at both the rising timing and the falling timing of the input data DATA_IN. As a result, the edge comparing means 3 identifies as to whether both the first detecting means 1 and the second detecting means 2 detect the amplitude values under the rising states of the input clocks CLK_IN1, or detect the amplitude values under the falling states thereof. Then, the edge comparing means 3 determines to invert/non-invert the polarities of the output of the first polarity inverting means 4 and the output of the second polarity inverting means 5 based upon the identification results, so that the polarities of the phase difference signals FEOs can be matched with each other.

### Third Embodiment

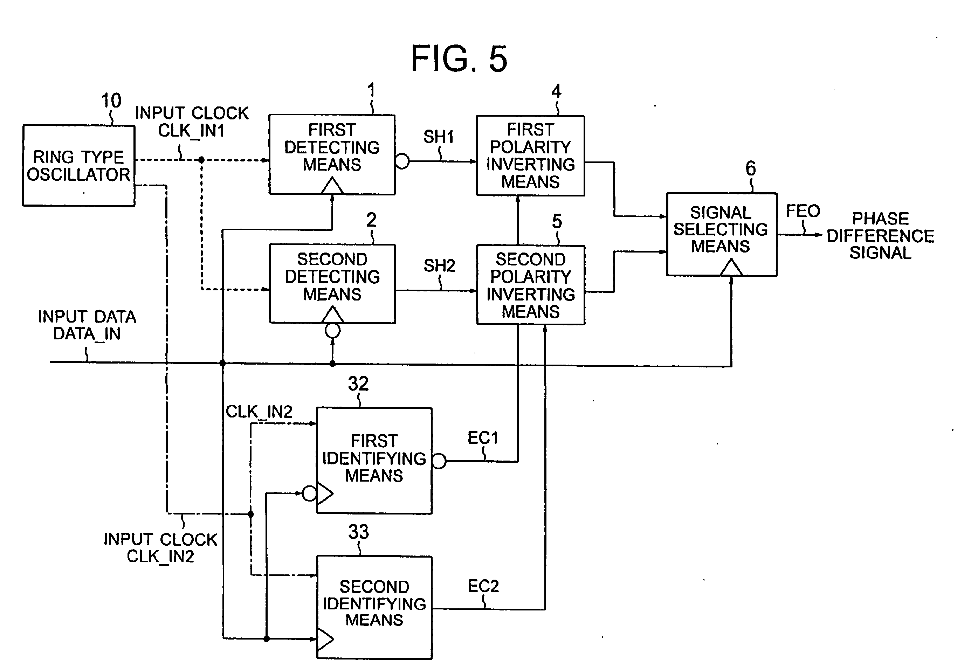

A phase comparator according to a third embodiment of the present invention will now be described with reference to FIG. 5. FIG. 5 is a block diagram for showing an arrangement of the phase comparator according to the third embodiment of the present invention.

In FIG. 5, the phase comparator, according to the third embodiment, is provided with a ring type oscillator 10, a first detecting means 1, a second detecting means 2, a first identifying means 32, a second identifying means 33, a first polarity inverting means 4, a second polarity inverting means 5, and a signal selecting means 6.

Since the ring type oscillator 10 is arranged by employing an even number of amplifiers whose circuit delay amounts are equal to each other, the ring type oscillator 10 can produces a clock CLK_IN1 (first clock signal), and another clock CLK_IN2 (second clock signal) whose phase is delayed by a 1/4 time period.

The first detecting means 1 starts a sampling operation for the amplitude of the input clock "CLK_IN1" at rising timing of the input data "DATA_IN", and holds the amplitude value of the input clock "CLK_IN1" at falling timing of the input data "DATA_IN" so as to detect the input clock "CLK_IN1". Then, the first detecting means 1 outputs such a signal that a polarity of the detected value is inverted as an "SH1" to the first polarity inverting means 4.

The second detecting means 2 starts a sampling operation for the amplitude of the input clock "CLK_IN1" at falling timing of the input data "DATA_IN", and holds the amplitude value of the input clock "CLK_IN1" at rising timing of the input data "DATA_IN" so as to detect the input clock "CLK_IN1". Then, the second detecting means 2 outputs such a signal as an "SH2" to the second polarity inverting means 5.

The first identifying means 32 identifies the 1/4-time-period delayed clock CLK_IN2 at falling timing of the input data DATA_IN, and thereafter, inverts the identification result, and then, outputs the inverted identification result as an "EC1" to the first polarity inverting means 4. The second identifying means 33 identifies the 1/4-time-period delayed clock CLK_IN2 at rising timing of the input data DATA_IN, and then, outputs the identification result as an "EC2" to the secondpolarity invertingmeans 5. The signal selecting means 6 selects either the output value of the first polarity inverting means 4 or the output value of the second polarity inverting means 5 in response to the polarity (either "H" or "L") of the input data DATA_IN to output the selected output value.

As previously explained, in the phase comparator of the third embodiment, the phase delay amount of the delayed clock CLK_IN2 required in the edge comparing means 3 becomes the 1/4 time period which is optimized in the first identifying means 32 and the second identifying means 33. It should also be noted that since a timing chart of the third embodiment is identical to that shown in FIG. 4, a description of the timing chart of the third embodiment is omitted.

## Claims

1. A phase comparator, comprising:
a first detecting means (1) for detecting a first amplitude value of a clock signal inputted at a falling edge of an inputted data signal by starting a sampling operation for an amplitude of the clock signal at a rising edge of the inputted data signal and holding the first amplitude value of the clock signal at the falling edge of the inputted data signal;
a second detecting means (2) for detecting a second amplitude value of the clock signal at a rising edge of the inputted data signal by starting a sampling operation for the amplitude of the clock signal at a falling edge of the inputted data signal and holding the second amplitude value of the clock signal at the rising edge of the inputted data signal;
an edge comparing means (3) for identifying as to whether the first detecting means (1) detects the first amplitude value during a rising state of the clock signal or the first amplitude value during a falling state of the clock signal by determining if the clock signal is in a falling state or a rising state during the falling edge of the inputted data signal to output a first identification result, and for identifying as to whether the second detecting means (2) detects the second amplitude value during a rising state of the clock signal or the second amplitude value during a falling state of the clock signal by determining if the clock signal is in a falling state or a rising state during the rising edge of the inputted data signal to output a second identification result;
a first polarity inverting means (4) for inverting the polarity of an output of the first detecting means (1) in response to the first identification result derived from the edge comparing means (3);
a second polarity inverting means (5) for inverting the polarity of an output of the second detecting means (2) in response to the second identification result derived from the edge comparing means (3); and
a signal selecting means (6) for selecting one of an output value of the first polarity inverting means (4) and an output value of the second polarity inverting means (5) in response to the polarity of the inputted data signal to output the selected output value.

2. A phase comparator according to claim 1, wherein the edge comparing means (3) comprises:
a phase delaying means (31) for delaying a phase of the clock signal;
a first identifying means (32) for identifying a third amplitude value of the delayed clock signal derived from the phase delaying means (31) at the falling edge of the inputted data signal and holding the third amplitude value until the inputted data signal is at a subsequent falling edge to output the first identification result; and
a second identifying means (33) for identifying a fourth amplitude of the delayed clock signal derived from the phase delaying means (31) at the rising edge of the inputted data signal and holding the fourth amplitude value until the inputted data signal is at a subsequent rising edge to output the second identification result.

3. A phase comparator according to claim 2, wherein the phase delaying means (31) delays the phase of the clock signal by a 1/4 time period.

4. A phase comparator, comprising:
a ring type oscillator (10) for producing a first clock signal and a second clock signal by delaying a phase of the first clock signal;
a first detecting means (1) for detecting a first amplitude value of the first clock signal produced from the ring type oscillator (10) at a falling edge of an inputted data signal by starting a sampling operation for an amplitude of the first clock signal at a rising edge of the inputted data signal and holding the first amplitude value of the first clock signal at the falling edge of the inputted data signal;
a second detecting means (2) for detecting a second amplitude value of the first clock signal produced from the ring type oscillator (10) at a rising edge of the inputted data signal by starting a sampling operation for the amplitude of the first clock signal at a falling edge of the inputted data signal and holding the second amplitude value of the first clock signal at the rising edge of the inputted data signal;
a first identifying means (32) for identifying a third amplitude value of the second clock signal produced from the ring type oscillator (10) at the falling edge of the inputted data signal and holding the third amplitude value until the inputted data signal is at a subsequent falling edge to output a first identification result;
a second identifying means (33) for identifying a fourth amplitude value of the second clock signal produced from the ring type oscillator (10) at the rising edge of the inputted data signal and holding the fourth amplitude value until the inputted data signal is at a subsequent rising edge to output a second identification result;
a first polarity inverting means (4) for inverting the polarity of an output of the first detecting means (1) in response to the first identification result derived from the first identifying means (32);
a second polarity inverting means (5) for inverting the polarity of an output of the second detecting means (2) in response to the second identification result derived from .the second identifying means (33); and
a signal selecting means (6) for selecting one of an output value of the first polarity inverting means (4) and an output value of the second polarity inverting means (5) in response to the polarity of the inputted data signal to output the selected output value.

5. A phase comparator according to claim 4, wherein the ring type oscillator (10) produces the second clock signal by delaying a phase of the first clock signal by a 1/4 time period.

## Patentansprüche

1. Phasenkomparator, welcher aufweist:
eine erste Erfassungsvorrichtung (1) zum Erfassen eines ersten Amplitudenwerts eines Taktsignals, das an einer abfallenden Flanke eines eingegebenen Datensignals eingegeben wurde, durch Starten eines Abtastvorgangs für eine Amplitude des Taktsignals an einer ansteigenden Flanke des eingegebenen Datensignals, und zum Halten des ersten Amplitudenwerts des Taktsignals an der abfallenden Flanke des eingegebenen Datensignals;
eine zweite Erfassungsvorrichtung (2) zum Erfassen eines zweiten Amplitudenwerts des Taktsignals an einer ansteigenden Flanke des eingegebenen Datensignals durch Starten eines Abtastvorgangs für die Amplitude des Taktsignals an einer abfallenden Flanke des eingegebenen Datensignals, und zum Halten des zweiten Amplitudenwerts des Taktsignals an der ansteigenden Flanke des eingegebenen Datensignals;
eine Flankenvergleichsvorrichtung (3) zum Identifizieren, ob die erste Erfassungsvorrichtung (1) den ersten Amplitudenwert während eines Anstiegszustands des Taktsignals oder den ersten Amplitudenwert während eines Abfallzustands des Taktsignals erfasst, durch Bestimmen, ob das Taktsignal in einem Abfallzustand oder einem Anstiegszustand während der abfallenden Flanke des eingegebenen Datensignals ist, um ein erstes Identifikationsergebnis auszugeben, und zum Identifizieren, ob die zweite Erfassungsvorrichtung (2) den zweiten Amplitudenwert während eines Anstiegszustands des Taktsignals oder den zweiten Amplitudenwert während eines Abfallzustands des Taktsignals erfasst, durch Bestimmen, ob das Taktsignal in einem Abfallzustand oder einem Anstiegszustand während der ansteigenden Flanke des eingegebenen Datensignals ist, um ein zweites Identifikationsergebnis auszugeben; eine erste Polaritätsinvertierungsvorrichtung (4) zum Invertieren der Polarität eines Ausgangssignals der ersten Erfassungsvorrichtung (1) als Antwort auf das von der Flankenvergleichsvorrichtung (3) abgeleitete erste Identifikationsergebnis; eine zweite Polaritätsinvertierungsvorrichtung (5) zum Invertieren der Polarität eines Ausgangssignals der zweiten Erfassungsvorrichtung (2) als Antwort auf das von der Flankenvergleichsvorrichtung (3) abgeleitete zweite Identifikationsergebnis; und eine Signalauswahlvorrichtung (6) zum Auswählen eines Ausgangswerts der ersten Polaritätsinvertierungsvorrichtung (4) oder eines Ausgangswerts der zweiten Polaritätsinvertierungsvorrichtung (5) als Antwort auf die Polarität des eingegebenen Datensignals, um den ausgewählten Ausgangswert auszugeben.

2. Phasenkomparator nach Anspruch 1, bei dem die Flankenvergleichsvorrichtung (3) aufweist:
eine Phasenverzögerungsvorrichtung (31) zum Verzögern einer Phase des Taktsignals;
eine erste Identifizierungsvorrichtung (32) zum Identifizieren eins dritten Amplitudenwerts des von der Phasenverzögerungsvorrichtung (31) abgeleiteten verzögerten Taktsignals an der abfallenden Flanke des eingegebenen Datensignals, und
zum Halten des dritten Amplitudenwerts, bis das eingegebene Datensignal an einer nachfolgenden abfallenden Flanke ist, um das erste Identifizierungsergebnis auszugeben; und
eine zweite Identifizierungsvorrichtung (33) zum Identifizieren einer vierten Amplitude des von der Phasenverzögerungsvorrichtung (31) abgeleiteten verzögerten Taktsignals an der ansteigenden Flanke des eingegebenen Datensignals, und
zum Halten des vierten Amplitudenwerts, bis das eingegebene Datensignal an einer nachfolgenden ansteigenden Flanke ist, um das zweite Identifikationsergebnis auszugeben.

3. Phasenkomparator nach Anspruch 2, bei dem die Phasenverzögerungsvorrichtung (31) die Phase des Taktsignals um 1/4 Zeitperiode verzögert.

4. Phasenkomparator, welcher aufweist:
einen Oszillator (10) vom Ringtyp zum Erzeugen eines ersten Taktsignals und eines zweiten Taktsignals durch Verzögern einer Phase des ersten Taktsignals;
eine erste Erfassungsvorrichtung (1) zum Erfassen eines ersten Amplitudenwerts des von dem Oszillator (10) vom Ringtyp erzeugten ersten Taktsignals an einer abfallenden Flanke eines eingegebenen Datensignals durch Starten eines Abtastvorgangs für eine Amplitude des ersten Taktsignals an einer ansteigenden Flanke des eingegebenen Datensignals, und zum Halten des ersten Amplitudenwerts des ersten Taktsignals an der abfallenden Flanke des eingegebenen Datensignals; eine zweite Erfassungsvorrichtung (2) zum Erfassen eines zweiten Amplitudenwerts des von dem Oszillator (10) vom Ringtyp erzeugten ersten Taktsignals an einer ansteigenden Flanke des eingegebenen Datensignals durch Starten eines Abtastvorgangs für die Amplitude des ersten Taktsignals an einer abfallenden Flanke des eingegebenen Datensignals, und zum Halten des zweiten Amplitudenwerts des ersten Taktsignals an der ansteigenden Flanke des eingegebenen Datensignals;
eine erste Identifizierungsvorrichtung (32) zum Identifizieren eines dritten Amplitudenwerts des von dem Oszillator (10) vom Ringtyp erzeugten zweiten Taktsignals an der abfallenden Flanke des eingegebenen Datensignals, und zum Halten des dritten Amplitudenwerts, bis das eingegebene Datensignal an einer nachfolgenden abfallenden Flanke ist, um ein erstes Identifikationsergebnis auszugeben;
eine zweite Identifizierungsvorrichtung (33) zum Identifizieren eines vierten Amplitudenwerts des von dem Oszillator (10) vom Ringtyp erzeugten zweiten Taktsignals an der ansteigenden Flanke des eingegebenen Datensignals, und zum Halten des vierten Amplitudenwerts, bis das eingegebene Datensignal an einer nachfolgenden ansteigenden Flanke ist, um ein zweites Identifikationsergebnis auszugeben;
eine erste Polaritätsinvertierungsvorrichtung (4) zum Invertieren der Polarität eines Ausgangssignals der ersten Erfassungsvorrichtung (1) als Antwort auf das von der ersten Identifizierungsvorrichtung (32) abgeleitete erste Identifikationsergebnis; eine zweite Polaritätsinvertierungsvorrichtung (5) zum Invertieren der Polarität eines Ausgangssignals der zweiten Erfassungsvorrichtung (2) als Antwort auf das von der zweiten Identifizierungsvorrichtung (33) abgeleitete zweite Identifikationsergebnis; und eine Signalauswahlvorrichtung (6) zum Auswählen eines Ausgangswerts der ersten Polaritätsinvertierungsvorrichtung (4) oder eines Ausgangswerts der zweiten Polaritätsinvertierungsvorrichtung (5) als Antwort auf die Polarität des eingegebenen Datensignals, um den ausgewählten Ausgangswert auszugeben.

5. Phasenkomparator nach Anspruch 4, bei dem der Oszillator (10) vom Ringtyp das zweite Taktsignal durch Verzögern einer Phase des ersten Taktsignals um 1/4 Zeitperiode erzeugt.

## Revendications

1. Comparateur de phase, comprenant :
un premier moyen de détection (1) destiné à détecter une première valeur d'amplitude d'un signal d'horloge entré au niveau d'un front descendant d'un signal de données entré en débutant une opération d'échantillonnage d'une amplitude du signal d'horloge au niveau d'un front montant du signal de données entré, et à bloquer la première valeur d'amplitude du signal d'horloge au niveau du front descendant du signal de données entré ;
un deuxième moyen de détection (2) destiné à détecter une deuxième valeur d'amplitude du signal d'horloge au niveau d'un front montant du signal de données entré en débutant une opération d'échantillonnage de l'amplitude du signal d'horloge au niveau d'un front descendant du signal de données entré, et à bloquer la deuxième valeur d'amplitude du signal d'horloge au niveau du front montant du signal de données entré ;
un moyen de comparaison de fronts (3) destiné à identifier si le premier moyen de détection (1) détecte la première valeur d'amplitude au cours d'un état montant du signal d'horloge ou la première valeur d'amplitude au cours d'un état descendant du signal d'horloge en déterminant si le signal d'horloge se trouve dans un état descendant ou dans un état montant au cours du front descendant du signal de données entré de manière à délivrer en sortie un premier résultat d'identification, et à identifier si le deuxième moyen de détection (2) détecte la deuxième valeur d'amplitude au cours d'un état montant du signal d'horloge ou la deuxième valeur d'amplitude au cours d'un état descendant du signal d'horloge en déterminant si le signal d'horloge se trouve dans un état descendant ou dans un état montant au cours du front montant du signal de données entré de manière à délivrer en sortie un deuxième résultat d'identification ;
un premier moyen d'inversion de polarité (4) destiné à inverser la polarité d'une sortie du premier moyen de détection (1) en réponse au premier résultat d'identification obtenu à partir du moyen de comparaison de fronts (3) ;
un deuxième moyen d'inversion de polarité (5) destiné à inverser la polarité d'une sortie du deuxième moyen de détection (2) en réponse au deuxième résultat d'identification obtenu à partir du moyen de comparaison de fronts (3) ; et
un moyen de sélection de signal (6) destiné à sélectionner l'une d'une valeur de sortie du premier moyen d'inversion de polarité (4) et d'une valeur de sortie du deuxième moyen d'inversion de polarité (5) en réponse à la polarité du signal de données entré de manière à délivrer en sortie la valeur de sortie sélectionnée.

2. Comparateur de phase selon la revendication 1, dans lequel le moyen de comparaison de fronts (3) comprend :
un moyen de retard de phase (31) destiné à retarder une phase du signal d'horloge ;
un premier moyen d'identification (32) destiné à identifier une troisième valeur d'amplitude du signal d'horloge retardé obtenu à partir du moyen de retard de phase (31) au niveau du front descendant du signal de données entré, et à bloquer la troisième valeur d'amplitude jusqu'à ce que le signal de données entré se situe au niveau d'un front descendant ultérieur de manière à délivrer en sortie le premier résultat d'identification ; et
un deuxième moyen d'identification (33) destiné à identifier une quatrième amplitude du signal d'horloge retardé obtenu à partir du moyen de retard de phase (31) au niveau du front montant du signal de données entré, et à bloquer la quatrième valeur d'amplitude jusqu'à ce que le signal de données entré se situe au niveau d'un front montant ultérieur de manière à délivrer en sortie le deuxième résultat d'identification.

3. Comparateur de phase selon la revendication 2, dans lequel le moyen de retard de phase (31) retarde la phase du signal d'horloge de 1/4 de période de temps.

4. Comparateur de phase, comprenant :
un oscillateur du type en anneau (10) destiné à produire un premier signal d'horloge et un deuxième signal d'horloge en retardant une phase du premier signal d'horloge ;
un premier moyen de détection (1) destiné à détecter une première valeur d'amplitude du premier signal d'horloge produit par l'oscillateur du type en anneau (10) au niveau d'un front descendant d'un signal de données entré en débutant une opération d'échantillonnage de l'amplitude du premier signal d'horloge au niveau d'un front montant du signal de données entré, et à bloquer la première valeur d'amplitude du premier signal d'horloge au niveau du front descendant du signal de données entré ;
un deuxième moyen de détection (2) destiné à détecter une deuxième valeur d'amplitude du premier signal d'horloge produit par l'oscillateur du type en anneau (10) au niveau d'un front montant du signal de données entré en débutant une opération d'échantillonnage de l'amplitude du premier signal d'horloge au niveau d'un front descendant du signal de données entré, et à bloquer la deuxième valeur d'amplitude du premier signal d'horloge au niveau du front montant du signal de données entré ;
un premier moyen d'identification (32) destiné à identifier une troisième valeur d'amplitude du deuxième signal d'horloge produit par l'oscillateur du type en anneau (10) au niveau du front descendant du signal de données entré, et à bloquer la troisième valeur d'amplitude jusqu'à ce que le signal de données entré se situe au niveau d'un front descendant ultérieur de manière à délivrer en sortie un premier résultat d'identification ;
un deuxième moyen d'identification (33) destiné à identifier une quatrième valeur d'amplitude du deuxième signal d'horloge produit par l'oscillateur du type en anneau (10) au niveau du front montant du signal de données entré, et à bloquer la quatrième valeur d'amplitude jusqu'à ce que le signal de données entré se situe au niveau d'un front montant ultérieur de manière à délivrer en sortie un deuxième résultat d'identification ;
un premier moyen d'inversion de polarité (4) destiné à inverser la polarité d'une sortie du premier moyen de détection (1) en réponse au premier résultat d'identification obtenu à partir du premier moyen d'identification (32) ;
un deuxième moyen d'inversion de polarité (5) destiné à inverser la polarité d'une sortie du deuxième moyen de détection (2) en réponse au deuxième résultat d'identification obtenu à partir du deuxième moyen d'identification (33) ; et
un moyen de sélection de signal (6) destiné à sélectionner l'une d'une valeur de sortie du premier moyen d'inversion de polarité (4) et d'une valeur de sortie du deuxième moyen d'inversion de polarité (5) en réponse à la polarité du signal de données entré de manière à délivrer en sortie la valeur de sortie sélectionnée.

5. Comparateur de phase selon la revendication 4, dans lequel l'oscillateur du type en anneau (10) produit le deuxième signal d'horloge en retardant une phase du premier signal d'horloge de 1/4 de période de temps.
